# EUROPEAN PATENT APPLICATION

(11) **EP 1 317 001 A1**
(43) Date of publication of application: **04.06.2003**
(21) Application number: 01310067.2
(22) Date of filing: 30.11.2001
(51) Int. Cl.: H01L 25/065, H01L 23/498, H01L 21/48

(54) **A semiconductor device**

(71) Applicant: Infineon Technologies AG, 81669 München (DE)
(72) Inventor: Yeo, Swain Hong, Singapore 560230 (SG)
(74) Representative: Howe, Steven

(57) **Abstract**

A semiconductor device (1) has a substrate (2) and a first semiconductor chip (3) mounted on the substrate (2). Electrical contacts (25) on the first chip (3) are electrically coupled to a first set of electrical contacts (21) on the substrate (2). An additional semiconductor chip (6) is mounted on the first semiconductor chip (3). Electrical contacts (26) on the additional semiconductor chip (6) are electrically coupled to an additional set of electrical contacts (22) on the substrate by electrically conducting paths formed on a flexible sheet of material (7) which extends from the electrical contacts (26) on the additional chip (6) to the additional set of electrical contacts (22) on the substrate (2).

## Description

The invention relates to a semiconductor device, and especially, a semiconductor device comprising two or more semiconductor chips.

Multi-chip module semiconductor devices are semiconductor device packages in which a first semiconductor chip is mounted on a substrate and a second semiconductor chip is then mounted on top of the first semiconductor chip. Conventionally, the first semiconductor chip is electrically connected to the substrate using flip chip technology and in particular, usually by solder bumps formed on the contact pads of the chip which contact with an identical pattern of a first set of contact pads on the substrate. The second chip is then electrically connected to the substrate, usually by wire bonding so that the wire bonds extend from the contact pads on the second semiconductor chip to a second set of contact pads on the substrate.

Such multi-chip modules are commonly used where it is desired to have a logic chip and a memory chip (such as a flash memory chip) in the same semiconductor device package. The logic chip is usually the chip with the larger footprint and so, is usually the chip that is attached directly to the substrate and the second chip is usually the memory chip.

However, with this arrangement, there is the disadvantage that the number of chips that can be stacked is limited to two chips, as the second chip must be attached to the first chip such that the contact pads of the second chip are facing away from the first chip to enable the wire bonding from the second chip to the substrate. However, the presence of these wire bonds on the upper surface of the second chip prevents further chips being mounted on top of the second chip.

In accordance with the present invention, there is provided a semiconductor device comprising a substrate, a first semiconductor chip mounted on the substrate, electrical contacts on the first chip being electrically coupled to a first set of electrical contacts on the substrate, and an additional semiconductor chip mounted on the first semiconductor chip, electrical contacts on the additional semiconductor chip being electrically coupled to an additional set of electrical contacts on the substrate by electrically conducting paths formed on a flexible sheet of material which extends from the electrical contacts on the additional chip to the additional set of electrical contacts on the substrate.

In accordance with a second aspect of the present invention, there is provided a method of assembling a semiconductor device, the method comprising attaching a first semiconductor chip to a substrate and establishing electrical connections between a set of electrical contacts on the first semiconductor chip and a first set of electrical contacts on the substrate; attaching a first portion of a flexible sheet of material to an additional semiconductor chip to electrically couple ends of electrically conducting pathways on the flexible sheet of material to a set of electrical contacts on the additional semiconductor chip, mounting the additional semiconductor chip on the first semiconductor chip, and attaching a second portion of the flexible sheet of material to the substrate to electrically couple the other ends of the electrically conducting pathways to an additional set of electrical contacts on the substrate.

Typically, the semiconductor device comprises a number of additional semiconductor chips, each additional semiconductor chip having a set of electrical contacts, the additional semiconductor chips being mounted on each other and on the first semiconductor chip, the substrate having an additional set of electrical contacts for each additional chip, and a flexible sheet of material having electrically conducting paths electrically coupling the set of electrical contacts on each additional semiconductor chip to the respective additional set of electrical contacts on the substrate.

Typically, the first semiconductor chip is electrically coupled to the substrate by means of electrically conducting bumps formed on the set of electrical contacts on the first semiconductor chip that are attached to the first set of electrical contacts on the substrate.

Typically, the electrically conducting bumps are formed from a solder material which are coupled to the first set of electrical contacts on the substrate by a solder reflow technique.

Typically, the flexible sheet of material is a polyimide material on which the electrically conducting paths are formed, and is typically, commonly known as "flexible circuit board".

Preferably, the flexible sheet of material extends from the additional semiconductor chip on only one side of the additional semiconductor chip.

Typically, where there is more than one additional semiconductor chip, the additional semiconductor chips are orientated such that each flexible sheet extends from the respective additional semiconductor chip in a different direction from the sheets of flexible material extending from the other additional semiconductor chips. Preferably, where there are two additional chips, the flexible sheets of material extend at 180° to each other or at 90° to each other. Where there are four additional semiconductor chips, each sheet of flexible material extends at 90° to the two adjacent flexible sheets of material.

Preferably, the electrically conducting paths on the sheet of material are electrically connected to the set of contacts on the additional chip and/or to the additional set of electrical contacts on the substrate by use of an anisotropic conductive paste or an anisotropic conductive film. Typically, the first semiconductor chip is attached to the substrate by a material which has a melting point that is higher than the material used to attach the flexible sheet of material to the substrate.

An example of a semiconductor device in accordance with the invention will now be described with reference to the accompanying drawings in which:
Figure 1 is a cross-sectional view of a semiconductor device;
Figure 2 is a plan view of the semiconductor device shown in Figure 1; and
Figures 3A to 3E show process steps for assembling the semiconductor device shown in Figures 1 and 2.

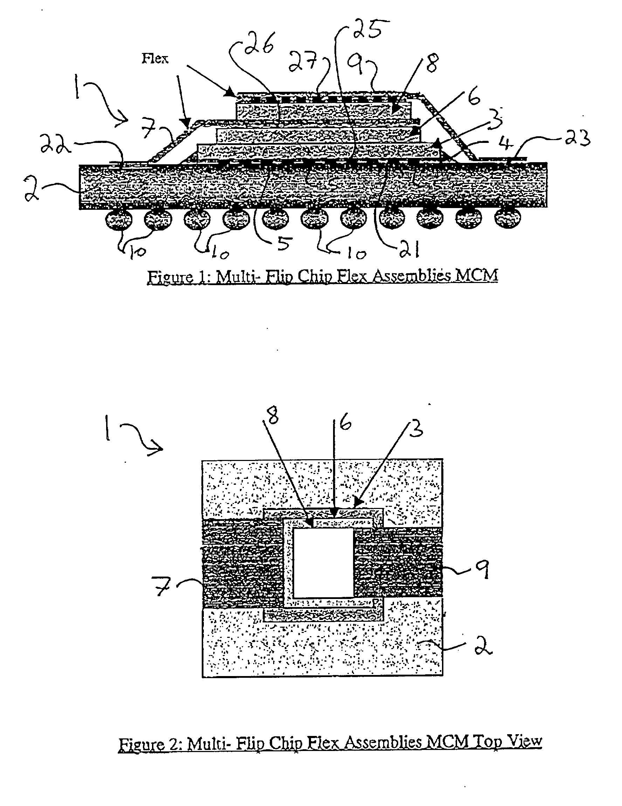

Figure 1 shows a semiconductor device 1 which includes a substrate 2, a first semiconductor chip 3 which is mechanically attached to the substrate 2 by solder bumps 5 using a conventional solder reflow technique. The solder bumps 5 also electrically couple contact pads 25 on the chip 3 to a first set of electrical contact pads 21 on the substrate 2. After attachment of the chip 3 to the substrate, the air gap between the chip 3 and the substrate 2 is filled with an underfill material 4.

Mounted on top of the first semiconductor chip 3 is a second semiconductor chip 6 having electrical contact pads 26. Typically, the second semiconductor chip 6 is attached to the first semiconductor chip 3 using an epoxy adhesive paste. The electrical contact pads 26 of the second semiconductor chip 6 are on the top surface of the semiconductor chip 6 and electrical conducting pathways formed on a flexible circuit board (flex) 7 electrically couple the contact pads 26 on the second semiconductor chip 6 to a second set of electrical contact pads 22 on the substrate 2.

A third semiconductor chip 8 having electrical contact pads 27 is attached to the top of the flex material 7 above the second chip 6, again using an epoxy adhesive paste. A second strip of flex 9 electrically couples the contact pads 27 on the top of the third semiconductor chip 8 to a third set of electrical contact pads 23 on the substrate 2.

In addition, the semiconductor device 1 also includes solder bumps 10 on the lower surface of the substrate 2 which permit the semiconductor device 1 to be electrically and mechanically coupled to an electrical circuit.

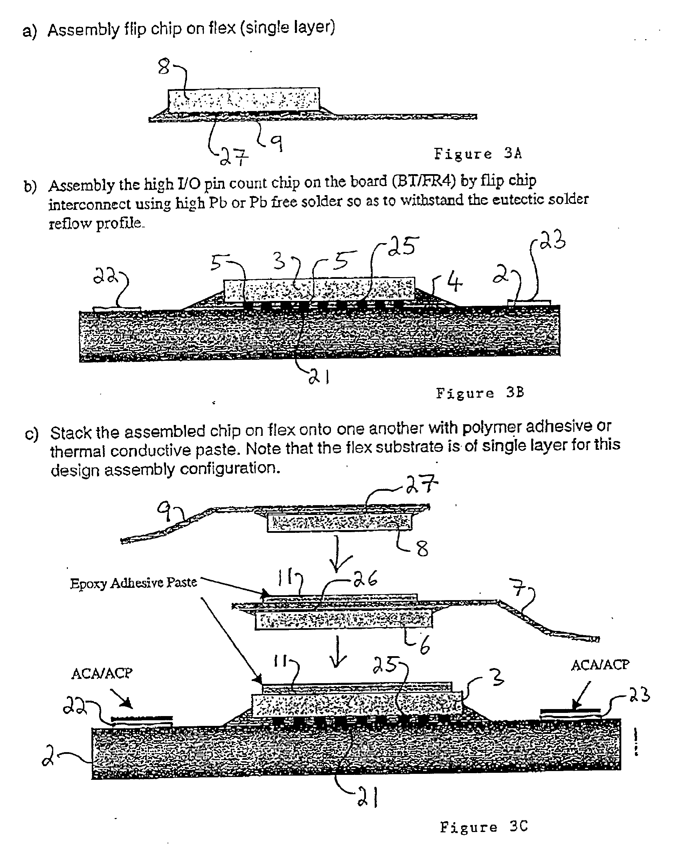

The process steps for assembling the semiconductor device 1 are shown in Figures 3A to 3E. As shown in Figure 3A, the third semiconductor chip 8 is electrically and mechanically connected to the flex strip 9. In a similar manner, the second semiconductor chip 6 is electrically and mechanically connected to the flex strip 7.

The first semiconductor chip 3 is then attached to the substrate 2 by a solder reflow technique which causes the solder bumps 5 to mechanically and electrically attach themselves to the first set of contact pads 21 on the substrate 2. An underfill material 4 is then used to fill the gaps between the solder bumps 5 and between the first semiconductor chip 3 and the surface of the substrate 2, as shown in Figure 3B.

As shown in Figure 3C, the surface of the second semiconductor chip 6 opposite to the flex strip 7 is attached to the top of surface of the first semiconductor chip 3 by an epoxy adhesive paste 11. In a similar manner, the surface of the third semiconductor chip 8 opposite to the flex strip 9 is attached to the flex strip 7 also by an epoxy adhesive paste 11. It should be noted that any suitable adhesive could be used to attach the second chip 6 to the first chip 3 and the third chip 8 to the flex 7. For example, the adhesive could be a polymer adhesive or a thermal conductive paste.

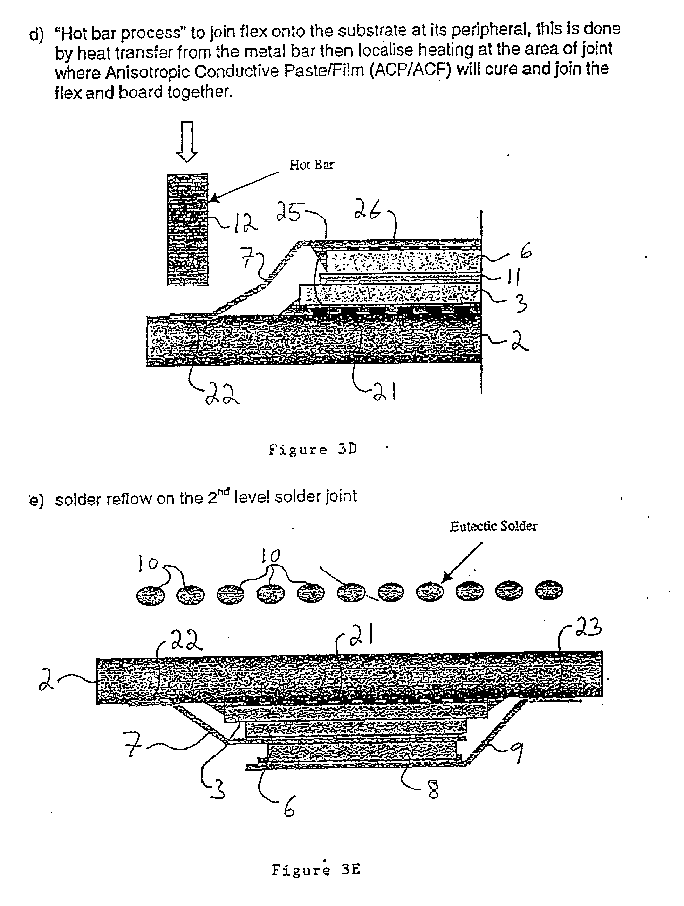

After the semiconductor chips 6, 8 have been stacked on top of the first semiconductor chip 3, the ends of the flex strips 7, 9 which are remote from the respective semiconductor chips 6, 8 are electrically connected to the corresponding set of electrical contact pads 22, 23 on the substrate 2 by applying an anisotropic conductive paste or film to the joint area between the remote ends of the flex strips 7, 9 and the corresponding set of electrical contact pads 22, 23 and using a heated metal bar 12 (see Figure 3D) to apply pressure and to cause localised heating at the area of the joint to cause the anisotropic conductive paste or film to cure and electrically connect the conducting paths on the flex strips 7, 9 to the corresponding set of electrical contact pads 22, 23 on the substrate 2.

Finally, as shown in Figure 3E, solder bumps 10 are formed on the underside of the substrate 2 to enable the semiconductor device 1 to be electrically connected to an electrical circuit.

It is possible that the solder used to attach the first chip 3 to the substrate could be a lead or lead-free solder and the solder bumps 10 on the underside of the substrate could be formed from a eutectic solder. This would have the advantage that the solder used to attach the first chip 3 to the substrate would have a higher melting point than the eutectic solder reflow profile. Therefore, it is less likely that solder reflow on the bumps 10 would have any detrimental effect on the attachment of the first chip 3 to the substrate 2.

Advantages of the invention are that by using flex to electrically couple the second chip 6 to the substrate, it is also possible to mount a third chip 8 on the first and second chips 3, 6. In addition, it would also be possible to mount a fourth and fifth chip on the third chip 8 if the substrate was provided with fourth and fifth sets of electrical contact pads 28, 29. Possible locations of the fourth and fifth sets 28, 29 are shown in phantom in Figure 2. With this arrangement, the second to fifth chips would be orientated so that each flex strip extends from its respective chip at 90° to the two adjacent flex strips.

## Claims

**1.** A semiconductor device comprising a substrate, a first semiconductor chip mounted on the substrate, electrical contacts on the first chip being electrically coupled to a first set of electrical contacts on the substrate, and an additional semiconductor chip mounted on the first semiconductor chip, electrical contacts on the additional semiconductor chip being electrically coupled to an additional set of electrical contacts on the substrate by electrically conducting paths formed on a flexible sheet of material which extends from the electrical contacts on the additional chip to the additional set of electrical contacts on the substrate.

**2.** A device according to claim 1, wherein the flexible sheet of material extends from the additional semiconductor chip on only one side of the additional semiconductor chip.

**3.** A device according to claim 1 or claim 2, wherein the electrically conducting paths on the sheet of material are electrically connected to the set of contacts on the additional chip and/or to the additional set of electrical contacts on the substrate by use of an anisotropic conductive paste or an anisotropic conductive film.

**4.** A device according to any of the preceding claims, wherein the first semiconductor chip is attached to the substrate by a material which has a melting point that is higher than a material used to attach the flexible sheet of material to the substrate.

**4.** A device according to any of the preceding claims, wherein the semiconductor device comprises a number of additional semiconductor chips, each additional semiconductor chip having a set of electrical contacts, the additional semiconductor chips being mounted on each other and on the first semiconductor chip, the substrate having an additional set of electrical contacts for each additional chip, and a flexible sheet of material having electrically conducting paths electrically coupling the set of electrical contacts on each additional semiconductor chip to the respective additional set of electrical contacts on the substrate.

**5.** A device according to claim 4, wherein the additional semiconductor chips are orientated such that each flexible sheet extends from the respective additional semiconductor chip in a different direction from the sheets of flexible material extending from the other additional semiconductor chips.

**6.** A device according to claim 5, comprising two additional chips, the flexible sheets of material extending at 180° to each other.

**7.** A device according to claim 5, comprising two additional chips, the flexible sheets of material extending at 90° to each other.

**8.** A device according to claim 5, comprising four additional semiconductor chips, each sheet of flexible material extending at 90° to the two adjacent flexible sheets of material.

**9.** A device according to any of the preceding claims, wherein the first semiconductor chip is electrically coupled to the first set of electrical contacts on the substrate by means of electrically conducting bumps formed on the set of electrical contacts on the first semiconductor chip that are attached to the first set of electrical contacts on the substrate.

**10.** A device according to claim 9, wherein the electrically conducting bumps are formed from a solder material.

**11.** A device according to any of the preceding claims, wherein the flexible sheet of material is an insulating material on which the electrically conducting paths are formed.

**12.** A device according to claim 11, wherein the insulating material is a polymer material.

**13.** A device according to claim 12, wherein the polymer material is a polyimide material.

**14.** A device according to any of the preceding claims, wherein electrically conducting bumps are formed on a surface of the substrate opposite to the surface on which the first semiconductor chip is mounted.

**15.** A method of assembling a semiconductor device, the method comprising attaching a first semiconductor chip to a substrate and establishing electrical connections between a set of electrical contacts on the first semiconductor chip and a first set of electrical contacts on the substrate; attaching a first portion of a flexible sheet of material to an additional semiconductor chip to electrically couple ends of electrically conducting pathways on the flexible sheet of material to a set of electrical contacts on the additional semiconductor chip, mounting the additional semiconductor chip on the first semiconductor chip, and attaching a second portion of the flexible sheet of material to the substrate to electrically couple the other ends of the electrically conducting pathways to an additional set of electrical contacts on the substrate.

**16.** A method according to claim 15, wherein a number of additional semiconductor chips are provided and the substrate comprises an additional set of electrical contacts for each additional semiconductor chip, attaching a first portion of a flexible sheet of material to each additional semiconductor chip to electrically couple ends of electrically conducting pathways on each flexible sheet of material to a set of electrical contacts on each respective additional semiconductor chip, mounting the additional semiconductor chips on each other and on the first semiconductor chip, and attaching a second portion of each flexible sheet of material to the substrate to electrically couple the other ends of the electrically conducting pathways to each respective additional set of electrical contacts on the substrate.

**17.** A method according to claim 15 or claim 16, wherein electrically conducting bumps are formed on the electrical contacts of the first semiconductor chip and are coupled to the first set of electrical contacts on the substrate by a solder reflow technique.

**18.** A method according to any of claims 15 to 17, wherein the electrically conducting paths on the sheet of material are electrically coupled to the set of contacts on the additional chip and/or to the additional set of electrical contacts on the substrate by use of an anisotropic conductive paste or an anisotropic conductive film.

**19.** A method according to any of claims 15 to 18, wherein the first semiconductor chip is attached to the substrate by a material which has a melting point that is higher than a material used to attach the flexible sheet of material to the substrate.
